# EUROPÄISCHE PATENTSCHRIFT

(11) **EP 2 011 094 B1**
(45) Veröffentlichungstag und Bekanntmachung des Hinweises auf die Patenterteilung: **08.09.2010**
(21) Anmeldenummer: 07718380.4
(22) Anmeldetag: 12.04.2007
(51) Int. Cl.: G08B 13/14

(54) **ALARMVORRICHTUNG**
ALARM APPARATUS
SYSTÈME D'ALARME

(30) Priorität: 21.04.2006 AT 6852006
(43) Veröffentlichungstag der Anmeldung: 07.01.2009
(73) Patentinhaber: Katoram Safety Solutions AG, 6300 Zug (CH)
(72) Erfinder: BRAUSTEINER, Thomas, 1160 Wien (AT); HAVERKAMP, Bernhard, 59387 Ascheberg (DE)
(74) Vertreter: Ellmeyer, Wolfgang
(86) Internationale Anmeldenummer: PCT/AT2007/000163
(87) Internationale Veröffentlichungsnummer: WO 2007/121493

(56) Entgegenhaltungen:
- WO-A-96/03866
- WO-A-2006/080879
- DE-U1- 9 110 342
- DE-U1- 9 201 087
- GB-A- 2 327 522

## Beschreibung

Die Erfindung betrifft eine transportable Alarmvorrichtung, welche eine Haftsaugvorrichtung, eine Vorrichtung zur Überwachung des Ansaug-Unterdrucks, die mit der Haftsaugvorrichtung verbunden ist, und eine Alarmsteuereinrichtung umfaßt, die mit einem Signalausgang der Vorrichtung zur Überwachung des Ansaug-Unterdruckes verbunden ist, insbesondere eine Alarmvorrichtung zum nachträglichen Einbau, welche für das Sichern von zu überwachenden Bereichen geeignet ist.

Die in der gegenständlichen Anmeldung erfolgte Bezugnahme auf Alarmvorrichtungen für Flugzeuge und Flughafengebäude stellt keine Einschränkung des Schutzumfanges dar sondern ist als beispielhafte Darstellung zu verstehen. Das Anwendungsgebiet der erfindungsgemäßen Alarmvorrichtung umfaßt vielmehr beliebige zu überwachende Bereiche, welche sowohl stationär als auch beweglich, z.B. in Fahrzeugen, sein können.

Trotz der Vielzahl an bereits bestehenden Alarmvorrichtungen konnten bestimmte, weiter unten noch genauer erläuterte Anforderungen bisher nicht erfüllt werden.

So ist beispielweise in der US 5 489 890 eine tragbare Alarmvorrichtung beschrieben, deren Gehäuse mit einem Saugnapf an einer passenden Oberfläche anbringbar ist, und die einen Kontakt im Inneren aufweist, der über eine zu einem anderen Saugnapf, der z.B. an einer Tür angesaugt ist, gespannte Schnur betätigbar ist. Das Gehäuse der Alarmvorrichtung wird zwar mittels Saugelement an einer Oberfläche angehaftet, dies geschieht aber bei unterschiedlicher Oberflächenbeschaffenheit in völlig unvorhersehbarer Weise. Die verwendeten einfachen Saugnäpfe weisen eine nicht kontrollierbare Haftfähigkeit auf, und es kann sehr leicht zu einem Ablösen kommen, weshalb diese Vorrichtung nur geringe Verläßlichkeit aufweist. Auch die Schnur zum Auslösen des Alarms durch Herstellung eines Kontaktes bei Herausziehen des am Schnurende angebrachten Streifens ist eine relativ unzuverlässige Maßnahme, die fehleranfällig ist und von außen mittels Durchtrennen der Schnur gestört werden kann.

In der DE 91 10 342 A ist eine Vorrichtung zur Sicherung von Gegenständen angegeben, bei der ein als Saugelement ausgebildeter Drucksensor an dem zu sichernden Gegenstand anbringbar ist und dieser Drucksensor in Abhängigkeit von dem im Saugelement herrschende Innendruck einen Alarm auslöst, wenn der Druck einen bestimmten Wert überschreitet. Das Saugelement wird durch Anpressen an der Oberfläche des zu sichernden Gegenstandes befestigt. Das Alarmgerät ist im Unterschied zur Erfindung nicht direkt auf dem Gegenstand befindlich sondern stationär vorhanden und über ein Kabel mit dem Drucksensor verbunden. Dieses Kabel kann mißbräuchlich durchtrennt werden. Ein weiterer Nachteil besteht in der Haftung des Saugelements am Gegenstand, die von den Umwelteinflüssen und von der Art der Oberfläche des Gegenstandes abhängig ist und daher Schwankungen unterworfen sein kann, die zum Ablösen des Saugelements von der Oberfläche führen kann.

Auch bei der pneumatischen Haftvorrichtung gemäß US 3 840 870 A wird der Druckanstieg in einem Saugelement bei Kontakt mit einem Gegenstand oder einer Fläche in ein Alarmsignal gewandelt. Das Arbeitsprinzip beruht nicht auf Unterdruck-Überwachung des Saugnapfes wie bei der Erfindung, weshalb bei Türüberwachungen eine eigene Mechanik notwendig ist, um eine Signalgebung zu erhalten. Weil solche konstruktiven Maßnahmen an der Tür oder am zu sichernden Bereich vermieden werden sollen, scheidet diese Vorrichtung zur Lösung der Aufgabe der Erfindung aus.

Für manche Anwendungen ist es erforderlich, eine Sicherung eines Bereiches vorzunehmen, für den keine konstruktiven Maßnahmen zur Verhinderung eines Eindringens in diesen Bereich getroffen worden sind, sei es, weil dies beim Errichten nicht bedacht worden ist oder weil es einzuhaltende Bestimmungen erfordern, daß keine Sperrvorrichtungen vorgesehen sind. Letzteres trifft z.B. bei Flugzeugen zu, weil aus Sicherheitsgründen keine ausfallgefährdeten Sperren für Kabinen- oder Eingangstüren vorgesehen werden dürfen. Daraus ergibt sich das Problem der Überwachung von auf Flugfeldern abgestellten Flugzeugen. Die üblichen Versiegelungen werden oftmals unsachgemäß vom Bodenpersonal geöffnet, sodaß nicht festgestellt werden kann, ob das betreffende Flugzeug von unautorisierten Personen betreten worden ist. Dieses Sicherheitsproblem tritt aber auch in anderen Bereichen auf, sodaß die gegenständliche Erfindung nicht auf die Sicherung von Flugzeugen beschränkt ist.

Ausgangspunkt für die erfinderischen überlegungen waren die auf Flugfeldern und auch in Flughafengebäuden vorherrschenden Sicherheitslücken.

Gemäß einer internationale Übereinkunft dürfen Flugzeuge keine Absperrvorrichtungen aufweisen, die im Notfall für die Passagiere ein unüberwindbares Hindernis oder ausfallsgefährdet wären. Daher muß ein Flugzeug von innen oder von außen jederzeit ohne Schlüssel oder sonstige Sperrvorrichtung geöffnet werden können. Auch sonstige Türüberwachungsmaßnahmen werden in einem sehr beschränkten Ausmaß zugelassen, da eine Fehlfunktion eine Beeinträchtigung der vollen Funktionsfähigkeit der Flugzeug-Bordtüre hervorrufen könnte.

Diese Vorschrift bringt Probleme bei der Absicherung von Flugzeugen auf Flugfeldern mit sich; denn aufgrund der geschilderten Situation können beliebige Personen das abgestellte Flugzeug betreten und wieder verlassen, ohne daß dies kontrolliert werden könnte.

Ziel der Erfindung ist es daher, eine transportable Alarmvorrichtung anzugeben,
- die eine zuverlässige Meldung über das Eindringen in einen zu sichernden Bereich ermöglicht,
- die z.B. unabhängig von der Bauweise einer Türe rasch angebracht werden und wieder abnehmbar sein kann,
- die ohne externe Energiequelle betrieben werden kann,
- die die Sicherungsfunktion verläßlich über einen längeren Zeitraum ausüben kann,
- deren Funktion von nicht autorisierten Personen praktisch nicht beeinträchtigt werden kann,
- die keine konstruktiven Änderungen, wie z.B. das Vorsehen eines Sperrmechanismus an der zu sichernden Türe erfordert.

Weitere Aufgabe der Erfindung ist es, eine Alarmvorrichtung der eingangs genannten Art anzugeben, die unabhängig von den baulichen und konstruktive Gegebenheiten einfach angebracht und auch jederzeit wieder entfernt werden kann, womit es auch ermöglicht wird, eine vorübergehende Sicherung eines Bereiches vorzunehmen, ohne daß dabei sicherheitsgefährdende Sperren oder Verriegelungen vorgesehen sein müssen.

Erfindungsgemäß wird dies dadurch erreicht,
daß die transportable Alarmvorrichtung ferner eine Vorrichtung zur Erzeugung eines Unterdruckes umfaßt, die mit der Haftsaugvorrichtung verbunden ist und welche den Unterdruck in der Haftsaugvorrichtung im angehafteten Zustand auf einen voreingestellten Wert im wesentlichen konstant hält,
und daß die transportable Alarmvorrichtung über die Haftsaugvorrichtung an einer Oberfläche eines zu überwachenden Bereiches anhaftbar ist, wobei die Alarmsteuereinrichtung bei Unterschreiten eines vorbestimmbaren Schwellwertes des Ansaug-Unterdruckes ein Alarmsignal erzeugt, wenn der voreingestellte Unterdruck nicht mehr aufrechterhalten werden kann.

Mittels der Haftsaugvorrichtung kann die erfindungsgemäße Alarmvorrichtung an jede dafür geeignete Oberfläche vorübergehend angebracht und nach Bedarf wieder abgenommen werden. Das unautorisierte Eindringen in den zu sichernden Bereich wird festgestellt und weitergemeldet, wenn der Ansaug-Unterdruck in der Haftsaugvorrichtung eine bestimmte Bereichsgrenze unterschreitet. Wird die Alarmvorrichtung nicht mehr benötigt kann sie jederzeit von der Oberfläche, an der

(Weiter auf Seite 5 der ursprünglichen Beschreibung) sie durch Saugwirkung angebracht ist, abgenommen werden. Bei abgestellten Flugzeugen kann somit eine Sicherung gegen ein Eindringen vorgenommen werden, ohne daß dabei an den Türen des Flugzeuges konstruktive Änderungen vorgenommen werden müssen. Diese Türen unterliegen speziellen Sicherheitsvorschriften, die Verriegelungen oder elektronische Sperr- bzw. Überwachungsvorrichtungen nicht gestatten. Für diesen sensiblen Bereich ist daher die erfindungsgemäße Alarmvorrichtung besonders wirkungsvoll anwendbar.

Mit Hilfe der Unterdruckerzeugungsvorrichtung kann das sichere und dauerhafte Anhaften der erfindungsgemäßen Alarmvorrichtung während des Überwachungsbetriebes gewährleistet werden.

Weiters ist die Vorrichtung zur Überwachung des Ansaug-Unterdrucks in der Haftsaugvorrichtung, vorzugsweise über Druckleitungen, mit der Haftsaugvorrichtung verbunden. Der Druck in den Druckleitungen wird ständig mit einer dafür vorgesehenen Meßeinrichtung gemessen. Sobald der Unterdruck stark abfällt, der Druck in den Leitungen z.B. sich dem Umgebungsluftdruck annähert, weil die Haftsaugvorrichtung von der Haftoberfläche abgenommen worden ist, wird das Alarmsignal ausgelöst.

Weiters ist der vorzugsweise elektrische Signalausgang der Vorrichtung zur Überwachung des Ansaug-Überdruckes mit der Alarmsteuereinrichtung verbunden, die ihrerseits mit zumindest einem Alarmgerät, z.B. eine GSM-Einheit, eine Videokamera, eine Schallerzeugungseinheit, eine Speichereinheit od. dgl. verbunden sein kann. Alle gängigen und bekannten Alarmsignale und -steuerungen können vorgesehen sein, um das Eindringen in den zu sichernden Bereich festzustellen und weiterzumelden, um entweder diese Aktivitäten aufzuzeichnen oder Abwehrmaßnahmen durch Sicherheitspersonal einzuleiten.

Die erfindungsgemäße Vorrichtung kann an der Außenhaut des abgestellten Flugzeuges jederzeit angebracht und aktiviert werden, um ein Öffnen der Bordtüren zu melden. Es ist die Erfindung aber auch zur Sicherung von anderen Sicherheitszonen, etwa in einem Flughafengebäude anwendbar. In einem solchen gibt es eine unübersehbare Anzahl von Türen, die aus Kostengründen nicht alle mit einem Sperr- oder Sicherheitsmechanismus ausgestattet sein können. Für einen bestimmten Anwendungsfall kann daher die erfindungsgemäße Vorrichtung angebracht und vorübergehend verwendet werden. Auf diese Weise können mit einer solchen Vorrichtung ständig sich ändernde Überwachungsbedürfnisse für mehrere Türen erfüllt werden.

Ein wichtiger Aspekt der Erfindung besteht in der Unabhängigkeit der erfindungsgemäßen Alarmvorrichtung von den konstruktiven Gegebenheiten des zu sichernden Bereiches. Gemäß einer Ausführungsform der Erfindung kann die Vorrichtung zur Überwachung des Ansaug-Unterdruckes und die Vorrichtung zur Erzeugung eines Unterdruckes daher im Inneren eines Gehäuses aufgenommen sein, wobei die Haftsaugvorrichtung an der Außenseite des Gehäuses angebracht ist. Die im Gehäuse untergebrachten Komponenten sind damit vor äußeren Einflüssen geschützt und es kann das Gehäuse als fertige Einheit mit Hilfe der Haftsaugvorrichtung an der Oberfläche des zu sichernden Bereiches angebracht werden.

Weiters kann vorgesehen sein, daß im Inneren des Gehäuses eine Energieversorgungseinheit vorgesehen ist, welche beispielsweise eine wiederaufladbare Batterie sein kann. Anstelle der wiederaufladbaren Batterie können aber auch andere, dem Fachmann bekannte Energiequellen Anwendung finden, welche eine unabhängige Versorgung gewährleisten, z.B. Solarzellen oder Brennstoffzellen od. dgl.

Die Haftsaugvorrichtung kann dabei aus einem oder mehreren Haftsaugern mit einer Haftsaugfläche zum Anhaften an der Oberfläche gebildet sein. Diese bekannten Haftsauger, die z.B. aus Gummi od. dgl. gebildet sein können, ermöglichen ein sehr gut haftendes Anbringen der erfindungsgemäßen Alarmvorrichtung z.B. an der Außenfläche eines Flugzeuges, und zwar bevorzugt auf der Türaußenwand und dem benachbarten Außenwandbereich des Flugzeugrumpfes, um ein Öffnen der Tür nachzuweisen. Während des Öffnungsvorgangs kommt es zu einem Ablösen der erfindungsgemäßen Alarmvorrichtung und diese kann dabei auf den darunterliegenden Boden fallen. Sie ist so stabil gebaut, daß diese Stoßwirkung keinen Einfluß auf die Funktion hat. Natürlich kann die erfindungsgemäße Alarmvorrichtung auch auf der Innenseite eines Flugzeuges oder eines anderen zu sichernden Bereiches angebracht werden.

Im Fall von Flugzeug-Bordtüren bilden diese mit dem umgebenden Bereich eine fast ebene Fläche aus. Für eine solche Anwendung hat es sich als vorteilhafte herausgestellt, wenn die Haftsaugvorrichtung aus zwei oder mehreren Haftsaugern gebildet ist, die an einer Außenfläche des Gehäuses voneinander beabstandet angeordnet sind, wobei ihre Haftflächen zu einer zur Außenfläche parallelen Ebene fluchtend ausgerichtet sind. Damit liegt das die Komponenten der erfindungsgemäßen Alarmvorrichtung enthaltende Gehäuse im angehafteten Zustand parallel über einem Flächenbereich, welcher den Türspalt beinhaltet.

Hingegen ist bei einfachen Türen ein Türstock und ein Türblatt vorgesehen, welches im geschlossenen Zustand im rechten Winkel zur Türstockinnenfläche zu liegen kommt. Damit für diesen Fall die Anbringung der erfindungsgemäßen Alarmvorrichtung keine Probleme mit sich bringt, kann die Haftsaugvorrichtung aus zwei oder mehreren Haftsaugern gebildet sein, die an zwei zueinander senkrecht stehenden Außenflächen des Gehäuses angeordnet sind. Die eine Außenfläche kann dabei parallel zum Türblatt und die andere Außenfläche parallel zur Türstockinnenfläche angehaftet werden.

Zur Erzielung einer konstanten Haftwirkung kann der oder die Haftsauger einen Durchgangskanal aufweisen, der an einem Ende in der Haftsaugfläche mündet und am anderen Ende mit der Vorrichtung zur Erzeugung eines Unterdrucks verbunden ist. Es kann der Unterdruck an der Haftsaugfläche aber auch konstruktiv anders gelöst sein. Kommt es zum Ablösen der Vorrichtung von der Oberfläche, an der sie anhaftet, so wird der Alarm ausgelöst.

Die Vorrichtung zur Erzeugung eines Unterdrucks kann eine Unterdruckpumpe, z.B. eine Vakuumpumpe sein.

Ein Aspekt der Erfindung ist somit die Verwendung der erfindungsgemäßen, transportablen Alarmvorrichtung zur Anbringung in einem zu überwachenden Türbereich.

Insbesondere bei Transporten von Wertgegenständen stellt sich oft das Problem, daß die Aufsicht über diese nur mangelhaft ist. So kommt es bei Geldtransporten immer wieder zu Sicherheitslücken, weil die beauftragte Wachmannschaft aus Nachlässigkeit Wagentüren offen stehen läßt, sodaß Behälter mit wertvollen Gegenständen oder Geldtaschen entwendet werden können. Um eine Entnahme z.B. aus einem Fahrzeug zu verhindern, kann vorgesehen sein, daß das Gehäuse der erfindungsgemäßen Alarmvorrichtung einen Behälter zur Verwahrung von zu sicherndem Gut aufweist. Dann kann die gesamte Alarmvorrichtung an einer Innenwand des Fahrzeugs und/oder an anderen Gegenständen bzw. Gehäusen von Alarmvorrichtungen angehaftet werden, wodurch ein Entwenden nur möglich ist, wenn die Alarmvorrichtung zusammen mit dem Behälter von der Wand und/oder einem anderen Gehäuse gelöst wird. Dieser Vorgang kann über die Alarmvorrichtung an eine Zentrale gemeldet werden, welche umgehend Sicherheitskräfte zum Ort des Geschehens entsendet.

Weiters kann der im Gehäuse untergebrachte Behälter verschließbar sein, und in ihm ein Unterdruck aufrechterhaltbar sein, wobei der Unterdruck mit einer Unterdrucküberwachungseinheit überwachbar ist, sodaß ein Alarmsignal erzeugt wird, wenn der Behälter unautorisiert geöffnet wird und dabei sich der Umgebungsdruck im Behälter einstellt. Es kann somit auch überwacht werden, wann der Behälter gewaltsam geöffnet wird. Dies ist in jenen Fällen von Bedeutung, in denen die Diebe den gestohlenen Behälter an einen anderen Ort bringen, um ihn dort aufzubrechen. Über eine GPS-Ortung kann somit dieser Vorgang örtlich lokalisiert werden.

Weitere Aufgabe der Erfindung ist es, eine Alarmvorrichtung anzugeben, welche einen Schutz gegen die Entnahme von Wertgegenständen aus einem zu überwachenden Bereich ermöglicht.

Dies wird durch die Verwendung einer erfindungsgemäßen, transportablen Alarmvorrichtung zur Anbringung in einem Transportbehälter, z.B. Container oder Transportfahrzeug, z.B. einem Geldtransportwagen erreicht.

Nachfolgend wird die Erfindung anhand der in den Zeichnungen dargestellten Ausführungsformen eingehend erläutert. Es zeigt dabei
Fig.1 eine schematische Darstellung einer Ausführungsform der erfindungsgemäßen transportablen Alarmvorrichtung;
Fig.2 eine schematische Darstellung einer weiteren Ausführungsform der erfindungsgemäßen transportablen Alarmvorrichtung und
Fig.3 eine schematische Darstellung einer weiteren Ausführungsform der erfindungsgemäßen transportablen Alarmvorrichtung.

Eine transportable Alarmvorrichtung 10 ist zur Sicherung eines Bereiches gegen ein Eindringen ausgebildet und wird vorzugsweise durch eine unabhängige Energieversorgungseinheit, z.B. eine wiederaufladbare Batterie 41 oder Akku, also netzunabhängig betrieben. In einem größeren Anwendungsmaßstab können mehrere Alarmvorrichtungen 10 zu einem Netzwerk, z.B. in Master/Slave-Betrieb zusammengeschaltet sein.

Der zu sichernde Bereich kann ohne Einschränkung des Schutzbereiches der Erfindung z.B. ein Flugzeug auf einem Flugfeld oder ein bestimmter Bereich eines Flughafengebäudes sein. Als transportabel wird die Alarmvorrichtung 10 deshalb bezeichnet, weil sie ohne bauliche Maßnahmen jederzeit am zu schützenden Bereich anbringbar und wieder abnehmbar ist.

Erfindungsgemäß ist eine Haftsaugvorrichtung 12 vorgesehen, mit der die Alarmvorrichtung 10, von der Teile im Inneren eines Gehäuse 1 untergebracht sind, an einer Oberfläche 15 einer Bereichsgrenze anhaftbar ist. Die Bereichsgrenze kann dabei z.B. durch eine Außenwand 11 eines Flugzeuges und ein Türblatt 16 gebildet sein, welches eine Einstiegsluke verschließt.

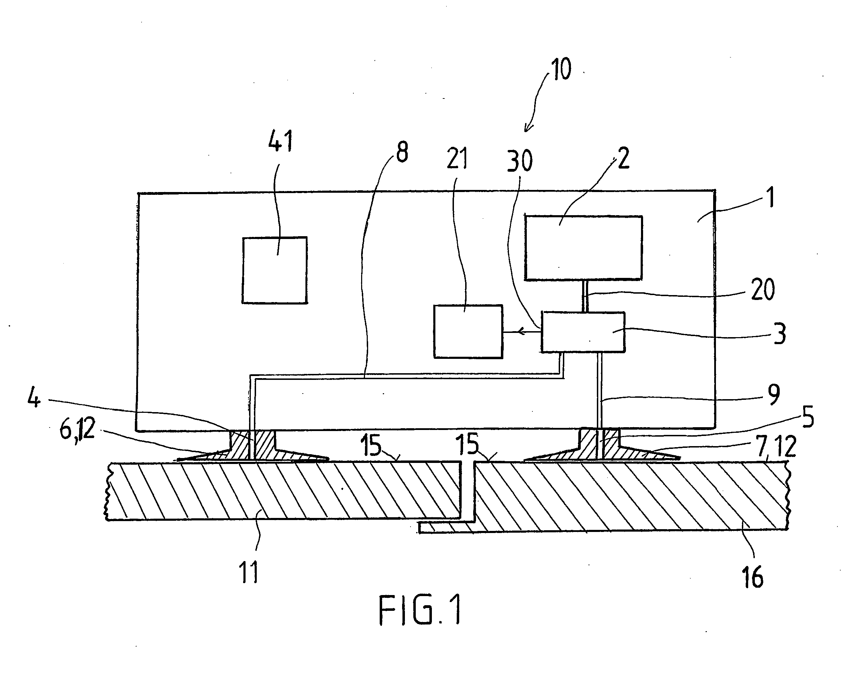

Die Haftsaugvorrichtung 12 ist im Ausführungsbeispiel gemäß Fig.1 aus zwei Gummi-Haftsaugern 6, 7 mit einer Haftsaugfläche zum Anhaften an der Oberfläche 15 gebildet, die an einer Außenfläche des Gehäuses 1 voneinander beabstandet angeordnet sind, wobei ihre Haftflächen zu einer zur Außenfläche parallelen Ebene fluchtend ausgerichtet sind, wodurch das Gehäuse 1 von der Oberfläche 15 parallel beabstandet an dieser angehaftet werden kann.

Es kann aber auch nur ein Haftsauger oder auch mehrere solcher vorgesehen sein. Die Anbringung der Haftsauger 6, 7 an der Alarmvorrichtung kann in einer nicht gezeigten Ausführungsform der Erfindung auch gelenkig ausgeführt sein.

Mittels der Gummi-Haftsauger 6, 7 wird das Gehäuse 1 der Alarmvorrichtung 10 an der Oberfläche 15, z.B. an einer Flugzeugaußenwand, der Bereichsgrenze angehaftet und dort gehalten.

Weiters ist erfindungsgemäß eine Vorrichtung 3 zur Überwachung des Ansaug-Unterdrucks in der Haftsaugvorrichtung 12 vorgesehen, die über Druckleitungen 8, 9 mit der Haftsaugvorrichtung 12 verbunden ist. Bei Unterschreiten eines vorbestimmbaren Schwellwertes des Unterdruckes wird ein Alarmsignal erzeugt.

Um den Ansaugdruck überwachen zu können, sind die Haftsauger 6, 7 jeweils mit einem Durchgangskanal 4, 5 ausgestattet, der an einem Ende in der Haftsaugfläche mündet und am anderen Ende einerseits mit der Vorrichtung 3 zur Überwachung des Unterdrucks und andererseits über diese mit einer Vorrichtung zur Erzeugung eines Unterdrucks 2 verbunden ist, die im angehafteten Zustand den Unterdruck in der Haftsaugvorrichtung 12 auf einen voreingestellten Wert im wesentlichen konstant hält. Der Unterdruck wird in den Leitungen 8, 9 durch eine Druckmeßeinrichtung in der Vorrichtung 3 überwacht und bei Absinken des Unterdruckes unter einen vorbestimmbaren Schwellenwert, z.B. 90% des Normalunterdruckes wird über eine Alarmsteuereinrichtung 21 ein Alarmsignal an einem vorzugsweise elektrischen Signalausgang 30 der Vorrichtung 3 erzeugt. Die Vorrichtung zur Erzeugung eines Unterdrucks 2 ist beispielsweise durch eine Unterdruckpumpe, z.B. eine Vakuumpumpe gebildet.

Der elektrische Signalausgang 30 der Vorrichtung 3 zur Überwachung des Ansaug-Überdruckes ist mit der das Alarmsignal erzeugenden Alarmsteuereinrichtung 21 verbunden, die ihrerseits mit zumindest einem Alarmgerät, z.B. einer GSM-Einheit, einer Videokamera, einer Schallerzeugungseinheit, einer Speichereinheit od. dgl. verbunden ist. Es kann also jegliche Art von Alarm erzeugt werden, z.B. in Form eines Not- oder Warnanrufes über eine Telephonverbindung, der Inbetriebnahme einer Videokamera, welche den Eindringling aufzeichnet, oder schlicht und einfach eines Schallsignals, das Sicherheitskräfte akustisch alarmiert.

Zugleich kann die Alarmsteuereinrichtung auch eine GPS-Ortungseinheit beinhalten, welche eine relativ genaue Ortung der erfindungsgemäßen Alarmvorrichtung 10 ermöglicht, falls dies für den jeweiligen Anwendungsfall erforderlich ist.

Bei der Inbetriebnahme der erfindungsgemäßen Alarmvorrichtung 10 wird diese vermittels der Haftsauger 6, 7 z.B. wie in Fig.1 über den Schließbereich einer Tür an der Bereichsgrenze angehaftet. Um die Haftwirkung verläßlich gewährleisten zu können, stellt die Vakuumpumpe 2 den Unterdruck durch eine Steuerung immer auf einen vorgegebenen Wert ein. Dadurch ist eine permanente Haftung der erfindungsgemäßen Alarmvorrichtung 10 an der Oberfläche 15 hergestellt.

Wird das Türblatt 16 von einem Eindringling geöffnet, so löst sich zumindest eine Haftfläche der Haftsauger 6, 7 soweit von der Oberfläche ab, daß der Schwellwert unterschritten wird, der vorgegebene Unterdruck kann nicht mehr von der Vakuumpumpe 2 aufrechterhalten werden und die Vorrichtung 3 stellt ein Unterschreiten des Schwellwertes fest, was das Erzeugen eines Alarmsignals am Ausgang 30 zur Folge hat. Mit diesem können über die Alarmsteuereinrichtung 21 beliebige Warn- und Alarmvorrichtungen angesteuert werden.

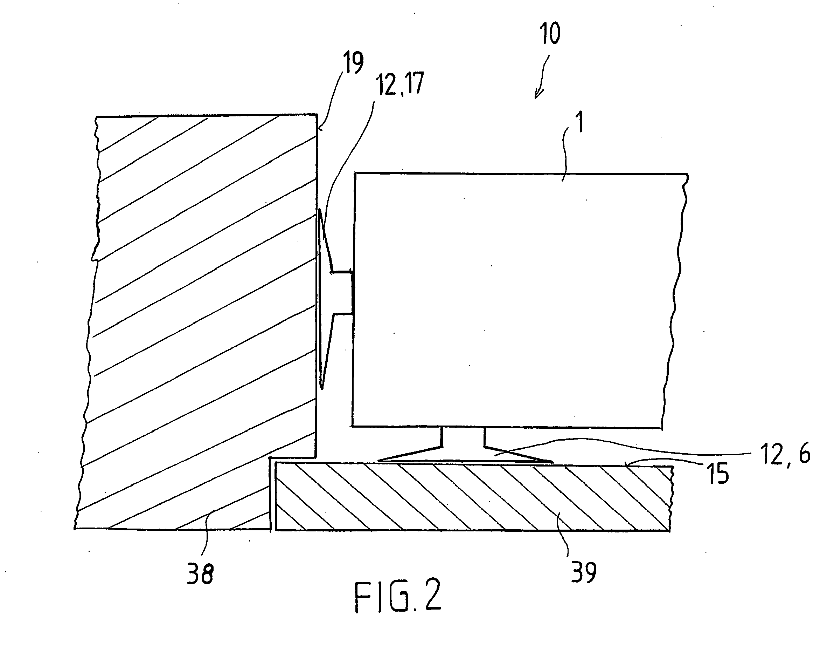

Fig.2 zeigt ein weiteres Ausführungsbeispiel der erfindungsgemäßen Alarmvorrichtung 10, welche das Anbringen an einflügeligen Türen erleichtert. In solchen Fällen liegt, wie in Fig.2 gezeigt, ein Türblatt 39 im geschlossenen Zustand an einem Türstock 38 an, sodaß sich auf einer Seite nicht ein fluchtender Verlauf des Türblatts 39 und des Türstocks 38 sondern ein zurückspringender Oberflächenbereich ergibt. Aus diesem Grund ist die Haftsaugvorrichtung 12 in diesem Fall aus zwei Haftsaugern 6, 17 gebildet, die an zwei zueinander senkrecht stehenden Außenflächen des Gehäuses 1 angeordnet sind, wodurch eine Anbringung der erfindungsgemäßen Alarmvorrichtung 10 erleichtert wird. Der innere Aufbau der Alarmvorrichtung 10 ist wie in Fig.1, wobei der zweite Haftsauger 17 in Fig.2 an die Stelle des Haftsaugers 7 in Fig.1 tritt.

Der Haftsauger 6 der einen Außenfläche des Gehäuses 1 haftet somit an der Oberfläche 15 des Türblattes 39 und der Haftsauger 17 des Gehäuses 1 an der Oberfläche 19 des Türstockes 38. Ein Öffnen des Türblattes 39 bringt den Haftsauger 6 und/oder den Haftsauger 17 zum Ablösen von dem Untergrund, an dem sie haften, woraufhin von der Alarmeinrichtung 21 ein Alarmsignal erzeugt wird.

Die Ausführungsformen gemäß Fig.1 und Fig.2 zeigen somit eine Verwendung der erfindungsgemäßen Alarmvorrichtung zur Anbringung in einem zu überwachenden Türbereich. Eine weitere mögliche Verwendung der erfindungsgemäßen transportablen Alarmvorrichtung besteht in der Anbringung in einem Transportbehälter, z.B. Container oder einem Transportfahrzeug, z.B. Geldtransportwagen. Auch stationäre Einsatzmöglichkeiten z.B. in einem Banksafe bestehen.

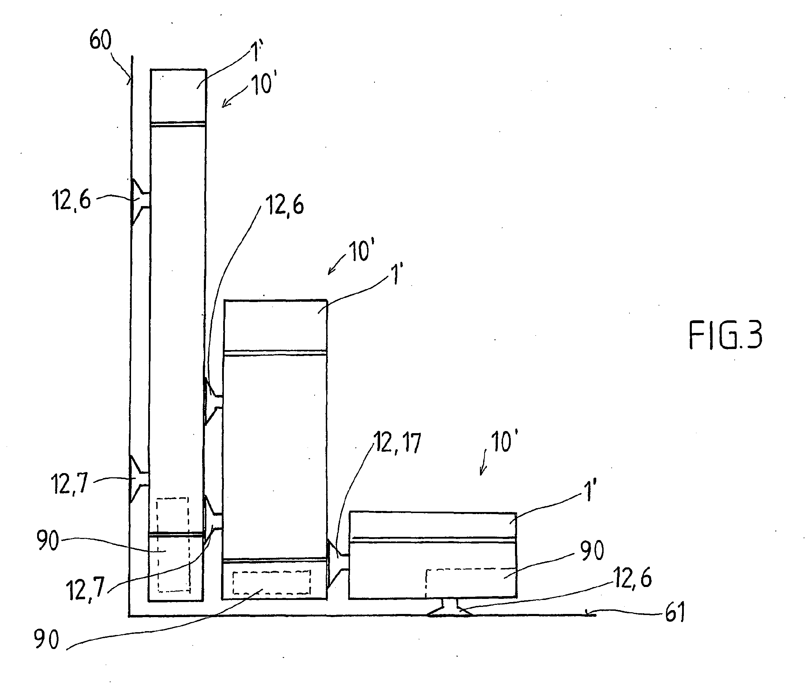

Dazu ist in Fig.3 eine Ausführungsform der erfindungsgemäßen Alarmvorrichtung 10' gezeigt, in der das Gehäuse 1' jeweils einen Behälter 90 zur Verwahrung von zu sicherndem Gut, z.B. wertvolle Kunstgegenstände, Bargeld, Schmuck, Wertpapiere od. dgl. aufweist. Insgesamt sind in Fig.3 beispielhaft drei Alarmvorrichtungen 10' mit verschieden großen Gehäusen 1' gezeigt, die in einem Innenraum z.B. eines Geldtransporters an Wänden 60, 61 und/ oder an eine jeweils benachbarte Alarmvorrichtung 10' angehaftet sind. Das gegenseitige Anhaften und Anhaften an den Wänden 60, 61 kann je nach Anzahl und Bauart der vorhandenen Gehäuse 1' variiert werden. Ein Ablösen eines oder mehrerer der Gehäuse 1' ruft ein Alarmsignal hervor, mit dem das Entwenden gemeldet oder ein wahrnehmbarer Alarm gegeben wird.

Als weitere Sicherheitsmaßnahme kann der im Gehäuse untergebrachte Behälter verschließbar sein, und in ihm z.B. während des Transports ein Unterdruck aufrechterhalten werden, wobei der Unterdruck mit einer nicht dargestellten Unterdrucküberwachungseinheit überwachbar ist, sodaß ein Alarmsignal erzeugt wird, wenn der Behälter unautorisiert geöffnet wird und dabei sich der Umgebungsdruck im Behälter einstellt. Da die erfindungsgemäße Alarmvorrichtung dafür erforderliche Einheiten bereits enthält, können diese für den genannten Zweck mitverwendet werden.

## Patentansprüche

1. Transportable Alarmvorrichtung (10, 10'), welche Folgendes umfaßt:
- eine Haftsaugvorrichtung (12),
- eine Vorrichtung (3) zur Überwachung des Ansaug-Unterdrucks, die mit der Haftsaugvorrichtung (12) verbunden ist,
- eine Alarmsteuereinrichtung (21), die mit einem Signalausgang (30) der Vorrichtung (3) zur Überwachung des Ansaug-Unterdruckes verbunden ist, **dadurch gekennzeichnet, daß** sie ferner eine Vorrichtung zur Erzeugung eines Unterdruckes (2) umfaßt, die mit der Haftsaugvorrichtung (12) verbunden ist und welche den Unterdruck in der Haftsaugvorrichtung (12) im angehaftete Zustand auf einen voreingestellten Wert im wesentlichen konstant hält,
daß die transportable Alarmvorrichtung (10, 10') über die Haftsaugvorrichtung (12) an einer Oberfläche (15, 19, 60, 61) eines zu überwachenden Bereiches anhaftbar ist, wobei die Alarmsteuereinrichtung (21) bei Unterschreiten eines vorbestimmbaren Schwellwertes des Ansaug-Unterdruckes ein Alarmsignal erzeugt, wenn der voreingestellte Unterdruck nicht mehr aufrechterhalten werden kann,
wobei die Vorrichtung (3) zur Überwachung des Ansaug-Unterdruckes und die Vorrichtung zur Erzeugung des Unterdruckes (2) im Inneren eines Gehäuses (1, 1') aufgenommen sind, wobei die Haftsaugvorrichtung (12) an der Außenseite des Gehäuses (1, 1') angebracht ist und das Gehäuse als fertige Einheit mit Hilfe der Haftsaugvorrichtung an der Oberfläche des abzusichernden Bereiches angebracht werden kann,
und wobei im Inneren des Gehäuses eine Energieversorgungseinheit vorgesehen ist, die eine unabhängige Versorgung gewährleistet.

2. Transportable Alarmvorrichtung nach Anspruch 1, **dadurch gekennzeichnet, daß** die Energieversorgungseinheit eine wiederaufladbare Batterie (41) ist.

3. Transportable Alarmvorrichtung nach Anspruch 1, oder 2, **dadurch gekennzeichnet, daß** die Haftsaugvorrichtung (12) aus einem oder mehreren Haftsaugern (6, 7, 17) mit einer Haftsaugfläche zum Anhaften an der Oberfläche (15, 19, 60, 61) des zu überwachenden Bereiches gebildet ist.

4. Transportable Alarmvorrichtung nach Anspruch 3, **dadurch gekennzeichnet, daß** die Haftsaugvorrichtung (12) aus zwei oder mehreren Haftsaugern (6, 7) gebildet ist, die an einer Außenfläche des Gehäuses (1) voneinander beabstandet angeordnet sind, wobei ihre Haftflächen zu einer zur Außenfläche parallelen Ebene fluchtend ausgerichtet sind.

5. Transportable Alarmvorrichtung nach Anspruch 3, **dadurch gekennzeichnet, daß** die Haftsaugvorrichtung (12) aus zwei oder mehreren Haftsaugern (6, 17) gebildet ist, die an zwei zueinander senkrecht stehenden Außenflächen des Gehäuses (1) angeordnet sind.

6. Transportable Alarmvorrichtung nach Anspruch 3, 4 oder 5, **dadurch gekennzeichnet, daß** der oder die Haftsauger (6, 7, 17) aus Gummi gebildet sind.

7. Transportable Alarmvorrichtung nach einem der Ansprüche 3 bis 6, **dadurch gekennzeichnet, daß** der oder die Haftsauger (6, 7, 17) einen Durchgangskanal (4, 5) aufweisen, der an einem Ende in der Haftsaugfläche mündet und am anderen Ende mit der Vorrichtung zur Erzeugung eines Unterdrucks (2) verbunden ist.

8. Transportable Alarmvorrichtung nach einem der vorhergehenden Ansprüche, **dadurch gekennzeichnet, daß** die Vorrichtung zur Erzeugung eines Unterdrucks (2) eine Vakuumpumpe ist.

9. Transportable Alarmvorrichtung nach einem der vorhergehenden Ansprüche, **dadurch gekennzeichnet, daß** die Vorrichtung (3) zur Überwachung des Ansaug-Unterdrucks in der Haftsaugvorrichtung Ober Druckleitungen (8, 9) mit der Haftsaugvorrichtung (12) verbunden ist.

10. Transportable Alarmvorrichtung nach einem der vorhergehenden Ansprüche, **dadurch gekennzeichnet, daß** die Alarmsteuereinrichtung (21) mit zumindest einem Alarmgerät, z.B. eine GSM-Einheit, eine Videokamera, eine Schallerzeugungseinheit, eine Speichereinheit od. dgl. verbunden ist.

11. Transportable Alarmvorrichtung nach einem der vorhergehenden Ansprüche, **dadurch gekennzeichnet, daß** die Vorrichtung zur Erzeugung eines Unterdruckes (2) über eine Druckleitung (20) mit der Vorrichtung (3) zur Überwachung des Unterdruckes und über diese mit der Haftsaugvorrichtung (12) verbunden ist.

12. Transportable Alarmvorrichtung nach einem der vorhergehenden Ansprüche, **dadurch gekennzeichnet, daß** das Gehäuse (1') einen Behälter (90) zur Verwahrung von zu sicherndem Gut aufweist.

13. Transportable Alarmvorrichtung nach Anspruch 12, **dadurch gekennzeichnet, daß** der im Gehäuse (1') untergebrachte Behälter (90) verschließbar ist, und in ihm ein Unterdruck aufrechterhaltbar ist, wobei der Unterdruck mit einer Unterdrucküberwachungseinheit überwachbar ist, sodaß ein Alarmsignal erzeugt wird, wenn der Behälter (90) unautorisiert geöffnet wird und dabei sich der Umgebungsdruck im Behälter (90) einstellt.

14. Verwendung einer transportablen Alarmvorrichtung (10) nach einem der vorhergehenden Ansprüche 1 bis 11 zur Anbringung in einem zu überwachenden Türbereich.

15. Verwendung einer transportablen Alarmvorrichtung (10') nach einem der vorhergehenden Ansprüche 1 bis 13 zur Anbringung in einem zu überwachenden Transportbehälter, z.B. Container oder Transportfahrzeug, z.B. einem Geldtransportwagen.

## Claims

1. A transportable alarm device (10, 10'), comprising:
- an adhesive suction device (12),
- a device (3) for monitoring the negative suction pressure, coupled to said adhesive suction device (12),
- an alarm control unit (21) which is connected to a signal output (30) of said device (3) for monitoring the negative suction pressure, **characterised in that** said device (10, 10') further comprises an apparatus for creating negative pressure (2) which is connected to said adhesive suction device (12) and which maintains the negative pressure in said adhesive suction device (12) in its adhered state substantially constant at a preset value,
**in that** said transportable alarm device (10, 10') may be adhered to a surface (15, 19, 60, 61) of an area to be surveilled by means of said adhesive suction device (12), said alarm control unit (21) producing an alarm signal in case the negative suction pressure falls below a predeterminable threshold value if the preset negative pressure can no longer be maintained,
said device (3) for monitoring the negative suction pressure and said apparatus for creating negative pressure (2) being accommodated within a housing (1, 1'), said adhesive suction device (12) being mounted onto the outside of said housing (1, 1'), and said housing, as a finished unit, being mountable onto the surface of the area which is to be secured,
a power supply unit being provided within said housing, guaranteeing an independent supply of power.

2. The transportable alarm device according to claim 1, **characterised in that** said power supply unit is a rechargeable battery (41).

3. The transportable alarm device according to claim 1 or claim 2, **characterised in that** said adhesive suction device (12) consists of one or several adhesive suction members (6, 7, 17), each with an adhesive suction surface for adhering to a surface (15, 19, 60, 61) of the area to be surveilled.

4. The transportable alarm device according to claim 3, **characterised in that** said adhesive suction device (12) consists of two or more adhesive suction members (6, 7) which are disposed on an outer surface of said housing (1) spaced apart from one another, their adhesive suction surfaces being aligned with a plane which is parallel to said outer surface.

5. The transportable alarm device according to claim 3, **characterised in that** said adhesive suction device (12) consists of two or more adhesive suction members (6, 17) which are disposed on two outer surfaces of said housing (1) which are vertical to one another.

6. The transportable alarm device according to any one of the claims 3, 4, or 5, **characterised in that** the adhesive suction member(s) (6, 7, 17) is/are formed of rubber.

7. The transportable alarm device according to any one of the claims 3 to 6, **characterised in that** the adhesive suction member(s) (6, 7, 17) has/each have a through channel (4, 5) which, at one of its ends, leads to the adhesive suction surface, and is connected to said apparatus for creating negative pressure (2) at its other end.

8. The transportable alarm device according to any one of the preceding claims, **characterised in that** said apparatus for creating negative pressure (2) is a vacuum pump.

9. The transportable alarm device according to any one of the preceding claims, **characterised in that** said device (3) for monitoring the negative suction pressure in the adhesive suction device is connected to said adhesive suction device (12) via pressure lines (8, 9).

10. The transportable alarm device according to any one of the preceding claims, **characterised in that** said alarm control unit (21) is connected to at least one alarm appliance, such as a GSM unit, a video camera, a sound generation unit, a storage unit, or the like.

11. The transportable alarm device according to any one of the preceding claims, **characterised in that** the apparatus for creating negative pressure (2) is connected to the device (3) for monitoring the negative pressure via a pressure line (20) and via said device (3) to the adhesive suction device (12).

12. The transportable alarm device according to any one of the preceding claims, **characterised in that** the housing (1') has a container (90) for safe-keeping goods to be protected.

13. The transportable alarm device according to claim 12, **characterised in that** the container (90) accommodated in the housing (1') is lockable and negative pressure may be maintained within it, the negative pressure being monitorable by means of a unit for monitoring negative pressure, so that an alarm signal is produced if said container (90) is opened without authorisation and the pressure within said container (90) increases to ambient pressure.

14. Use of a transportable alarm device (10) according to any one of the preceding claims 1 to 11 for being mounted in a door area which is to be surveilled.

15. Use of a transportable alarm device (10') according to any one of the preceding claims 1 to 13 for being mounted in a transport container which is to be surveilled, such as a container or a transport vehicle, such as a money transporter.

## Revendications

1. Dispositif d'alarme (10, 10') transportable, comprenant:
- un dispositif de succion adhésive (12),
- un dispositif (3) pour surveiller la pression de succion négative, relié audit dispositif de succion adhésive (12),
- une installation de commande d'alarme (21) qui est reliée avec une sortie de signaux (30) dudit dispositif (3) pour surveiller la pression de succion négative, **caractérisé en ce que** ledit dispositif comprend d'ailleurs un dispositif pour créer une pression négative (2) qui est relié audit dispositif de succion adhésive (12) et qui maintient la pression négative dans ledit dispositif de succion adhésive (12), dans son état adhérent, essentiellement constamment à une valeur préajustée,
**en ce que** ledit dispositif d'alarme (10, 10') transportable peut être adhéré à une surface (15, 19, 60, 61) d'un domaine à surveiller en utilisant ledit dispositif de succion adhésive (12), ladite installation de commande d'alarme (21) produisant un signal d'alarme si la pression de succion négative descend sous une valeur de seuil prédéterminable quand la pression négative préajustée ne peut plus être maintenue,
ledit dispositif (3) pour surveiller la pression de succion négative et ledit dispositif pour créer une pression négative (2) étant contenus dans l'intérieur d'un boîtier (1, 1'), ledit dispositif de succion adhésive (12) étant fixé à l'extérieur dudit boîtier (1, 1') et ledit boîtier, comme un tout fini, étant fixable à la surface du domaine à protéger à l'aide dudit dispositif de succion adhésive,
et une unité d'alimentation en énergie, garantissant une alimentation indépendante, étant fournie à l'intérieur dudit boîtier.

2. Dispositif d'alarme transportable selon la revendication 1, **caractérisé en ce que** ladite unité d'alimentation en énergie est une pile rechargeable (41).

3. Dispositif d'alarme transportable selon la revendication 1 ou la revendication 2, **caractérisé en ce que** ledit dispositif de succion adhésive (12) est formé par un ou plusieurs éléments de succion adhésive (6, 7, 17) avec une surface de succion adhésive pour adhérer à une surface (15, 19, 60, 61) du domaine à surveiller.

4. Dispositif d'alarme transportable selon la revendication 3, **caractérisé en ce que** ledit dispositif de succion adhésive (12) est formé par deux ou plusieurs éléments de succion adhésive (6, 7) qui sont aménagés, écartés l'un de l'autre, sur une surface extérieure dudit boîtier (1), leurs surfaces de succion adhésive étant en alignement avec un plan qui est parallèle à ladite surface extérieure.

5. Dispositif d'alarme transportable selon la revendication 3, **caractérisé en ce que** ledit dispositif de succion adhésive (12) est formé par deux ou plusieurs éléments de succion adhésive (6, 17) qui sont aménagés sur deux surfaces extérieures dudit boîtier (1) dont l'un est disposée d'une manière verticale par rapport à l'autre.

6. Dispositif d'alarme transportable selon la revendication 3, 4 ou 5, **caractérisé en ce que** ledit élément/lesdits éléments de succion adhésive (6, 7, 17) consiste/consistent en caoutchouc.

7. Dispositif d'alarme transportable selon l'une des revendications 3 à 6, **caractérisé en ce que** ledit élément/lesdits éléments de succion adhésive (6, 7, 17) ont un conduit de passage (4, 5) dont l'un des bouts mène à la surface de succion adhésive et l'autre est relié au dispositif pour créer une pression négative (2).

8. Dispositif d'alarme transportable selon l'une des revendications précédentes, **caractérisé en ce que** ledit dispositif pour créer une pression négative (2) est une pompe à vide.

9. Dispositif d'alarme transportable selon l'une des revendications précédentes, **caractérisé en ce que** ledit dispositif (3) pour surveiller la pression de succion négative dans ledit dispositif de succion adhésive est relié audit dispositif de succion adhésive (12) via des conduites de pression (8, 9).

10. Dispositif d'alarme transportable selon l'une des revendications précédentes, **caractérisé en ce que** ladite installation de commande d'alarme (21) est reliée à au moins un appareil d'alarme, par exemple une unité GSM, une caméra vidéo, une unité génératrice de son, une unité de stockage etc.

11. Dispositif d'alarme transportable selon l'une des revendications précédentes, **caractérisé en ce que** ledit dispositif pour créer une pression négative (2) est relié audit dispositif (3) pour surveiller la pression de succion négative via une conduite de pression (20) et via ledit dispositif (3) audit dispositif de succion adhésive (12).

12. Dispositif d'alarme transportable selon l'une des revendications précédentes, **caractérisé en ce que** ledit boîtier (1') a un récipient (90) pour garder des biens à protéger.

13. Dispositif d'alarme transportable selon la revendication 12, **caractérisé en ce que** ledit récipient (90) qui est contenu dans ledit boîtier (1') est fermable à clé et **en ce qu'**une pression négative peut être maintenue à l'intérieur dudit récipient (90), la pression négative pouvant être surveillée par une unité de surveillance de la pression négative ainsi qu'un signal d'alarme est généré si ledit récipient (90) est ouvert sans autorisation et la pression dans ledit récipient (90) atteint la pression ambiante.

14. Utilisation d'un dispositif d'alarme transportable selon l'une des revendications précédentes 1 à 11 pour être installé aux environs d'une porte.

15. Utilisation d'un dispositif d'alarme transportable (10') selon l'une des revendications précédentes 1 à 13 pour être installé dans un conteneur de transport à surveiller, par exemple un conteneur ou un véhicule de transport, par exemple un fourgon de transport de fonds.
